# EUROPÄISCHE PATENTSCHRIFT

(11) **EP 1 014 030 B1**
(45) Veröffentlichungstag und Bekanntmachung des Hinweises auf die Patenterteilung: **25.06.2003**
(21) Anmeldenummer: 99124980.6
(22) Anmeldetag: 15.12.1999
(51) Int. Cl.: G01B 5/00, H01L 21/00, G01B 9/02, G01B 11/00

(54) **Messtischanordnung mit einem verfahrbaren X/Y-Koordinaten-Messtisch**
Measurement table arrangement comprising a movable x/y stage for coordinate measurement
Arrangement de table de mesure comprenant une table déplaçable en x/y pour détermination de coordonnées

(30) Priorität: 17.12.1998 DE 19858428
(43) Veröffentlichungstag der Anmeldung: 28.06.2000
(73) Patentinhaber: Leica Microsystems Wetzlar GmbH, 35578 Wetzlar (DE)
(72) Erfinder: Kaczynski, Ulrich, 61231 Bad Nauheim (DE)
(74) Vertreter: Reichert, Werner F., Dr.

(56) Entgegenhaltungen:
- EP-A- 0 604 380
- DE-A- 3 400 265
- GB-A- 2 080 954
- US-A- 4 583 847
- US-A- 5 151 749
- US-A- 5 325 180

## Beschreibung

Die Erfindung betrifft eine Meβtischanordnung mit einem verfahrbaren x/y-Koordinaten-Meßtisch zur interferometrischen Positionsbestimmung. Eine solche Anordnung ist im Oberbegriff des unabhängigen Anspruchs 1 definiert.

Meßtischanordnungen der eingangs genannten Art finden in Wafer-Steppern und in hochgenauen Koordinaten-Meßgeräten Verwendung. Sie ermöglichen einerseits mittels der an ihnen angebrachten Meßspiegel eine interferometrische Bestimmung ihrer aktuellen Position und tragen andererseits die zu untersuchenden oder zu bearbeitenden Substrate.

Eine Meßtischanordnung der eingangs genannten Art ist in der deutschen Patentanmeldung DE 198 19 492.7-52 als Bestandteil eines Koordinaten-Meßgeräts beschrieben. Dieses Meßgerät dient zur hochgenauen Messung der Koordinaten von Strukturen auf Substraten, z.B. Masken und Wafem, insbesondere aber für transparente Substrate. Zur Aufnahme der Substrate dient ein Meßtisch, der vertikal und horizontal verschiebbar ist. Der Meßtisch weist einen Aufnahmerand für das Substrat auf und ist mit einer rahmenförmigen Öffnung ausgestattet, um die aufgelegten Substrate sowohl von oben als auch von unten erreichen zu können. An zwei zueinander senkrechten Seiten des Meßtischs sind ebene Spiegel als Meßspiegel für ein Laser-Interferometer-System angebracht, das die x/y-Position des Meßtischs bestimmt.

Das Meßgerät besitzt eine Auflicht-Beleuchtungseinrichtung und eine Durchlicht-Beleuchtungseinrichtung mit einer gemeinsamen optischen Achse durch die Öffnung des Meßtischs. Ferner sind eine Abbildungs-Einrichtung und eine Detektor-Einrichtung für die abgebildeten Strukturen vorhanden. Die gemessenen Koordinaten einer Struktur ergeben sich aus der aktuellen, interferometrisch gemessenen Position des Meßtischs und der Lage der zu messenden Struktur relativ zur optischen Achse.

Eine weitere Meßtischanordnung mit verfahrbaren x/y-Koordinatenmeβtisch, der auf drei Auflagepunkten einen Wafer trägt, ist aus US-A-4583847 bekannt. Auch hier wird die Position von seitlich angebrachten Spiegeln Laseroptisch gemessen.

In dem Artikel "Maskenmetrologie mit der LEICA LMS IPRO für die Halbleiterproduktion" von K.-D. Röth und K. Rinn, Mitteilungen für Wissenschaft und Technik Bd. XI, Nr. 5, Seite 130-135, Oktober 1997, ist ein Koordinaten-Meßgerät angegeben, in dem ein Meßtisch der eingangs genannten Art zur Aufnahme der zu vermessenden Substrate dient. Es weist ein Interferometer und für jede Koordinatenachse (x,y) des Meßtischs einen separaten Interferometer-Meßstrahlengang auf. An zwei zueinander senkrecht stehenden Seiten des Meßtischs sind Meßspiegel angebracht, die sich an den Enden der beiden Interferometer-Meßstrahlengänge befinden. Mittels der beiden Meßspiegel kann die Position des Meßtisches interferometrisch bestimmt werden. Diese geht direkt in die Bestimmung der Koordinaten von Strukturen auf den Substraten ein.

Um für die Koordinaten der Strukturen eine Meßgenauigkeit im Nanometerbereich erreichen zu können, werden die verschiedensten Fehlerquellen des Meßgeräts meßtechnisch berücksichtigt. Es wird eine Reihe von Fehlerquellen und Methoden zu ihrer Behebung ausführlich beschrieben.

So ist zur Entkopplung von Gebäudeschwingungen das Meßgerät auf einem schwingungsgedämpft luftgelagerten Granitblock angeordnet, auf welchem wiederum der Meßtisch luftgelagert ist. Um die Auswirkungen der Änderungen von Luftfeuchte und Temperatur zu minimieren, ist das Meßgerät in einer Klimakammer aufgestellt. Weil die Wellenlänge des Interferometer-Meßlichts von Luftdruck, Temperatur, Feuchtigkeit und Zusammensetzung der Luft abhängig ist, wird durch eine Vergleichsmessung an einem Etalon der aktuelle Wert der Wellenlänge fortlaufend bestimmt und bei der Berechnung der Meßergebnisse berücksichtigt.

Auch die Geometrie der Meßspiegel erweist sich als fehlerkritisch, weil undefinierte Änderungen in der Spiegelgeometrie zu Fehlern in der Positionsbestimmung des Meßtisches führen. Diese Problematik tritt generell bei Meßtischen mit interferometrischer Positionsbestimmung auf, unabhängig davon, ob sie in Koordinaten-Meßgeräten oder in Steppern verwendet werden.

Für eine fehlerfreie interferometrische Positionsbestimmung des Meßtisches ist es immer erforderlich, daß die Meßspiegel exakt orthogonal zu einander angeordnet, nicht verkippt und eben sind. Da diese Forderungen nicht auf Nanometer genau realisiert werden können, werden die Restfehler der Meßspiegel bezüglich Spiegelebenheit, Orthogonalität und Verkippung bestimmt und mittels Software-Korrekturen kompensiert. Diese Software-Korrekturen setzen aber voraus, daß sich die ermittelten Spiegelfehler während des Meßbetriebs, also auch nach einem Wechsel der zu untersuchenden Maske, nicht ändern. Daher sind die beiden Meßspiegel aus einem Material mit extrem niedrigen Ausdehnungskoeffizienten gefertigt, um die Temperatur-Einflüsse auf die Spiegelgeometrie zu minimieren.

Da die Meßspiegel jedoch an dem Meßtisch befestigt sind, erweist sich der Meßtisch selbst als kritische Komponente bei der Fehlerbetrachtung. So zeigt er infolge der flexiblen Luftlagerung geringfügige Deformationen, die zu einer Beeinträchtigung der Spiegelgeometrie führen. Zusätzlich weisen die untersuchten Masken und Wafer unterschiedliche Abmessungen und Gewichte auf. Dabei wiegt beispielsweise die leichteste Maske nur ca. 80 g, die schwerste jedoch ca. 1,4 kg. Waferchucks sind noch deutlich schwerer. Werden nacheinander Substrate mit sehr unterschiedlichen Gewichten auf den Meßtisch aufgelegt, so deformiert sich der Meßtisch jedesmal unterschiedlich.

Auch beim Verfahren verzieht sich der Meßtisch geringfügig. Denn beim Verfahren des Meßtisches gleitet er auf den Luftlagern auf dem Granitblock, dessen Oberfläche jedoch nicht auf Nanometer genau eben ist. Als Folge dieser Restunebenheit des Granitblocks wird der Meßtisch beim Verfahren deformiert. Diese Deformationen des Meßtischs wiederum verursachen Deformationen der an ihm befestigten Meßspiegel und eine Änderung der relativen Lage der Meßspiegel zueinander. Außerdem ändert sich die Position des Substrats relativ zu den Meßspiegeln, und die Substrate werden durch Deformation des Meßtisches ebenfalls verformt. Alle diese Deformationen und Lageänderungen sind zwar sehr klein, aber sie beeinflussen in nichtreproduzierbarer Weise die Spiegelgeometrie. Dies führt bei Koordinaten-Meßmaschinen zu Fehlern in den Meßergebnissen. Bei Steppem ergeben sich daraus Positionierungsfehlem bei den einzelnen Belichtungsvorgängen.

Es ist daher Aufgabe der vorliegenden Erfindung, eine Meßtischanordnung mit einem verschiebbaren x/y-Koordinaten-Meßtisch mit Meßspiegeln zur interferometrischen Positionsbestimmung anzugeben, bei dem die thermisch bedingten und durch Laständerungen verursachten Veränderungen der Meßtisch-Geometrie keinen Einfluß auf die Geometrie der Meßspiegel haben und die Lage der Meßspiegel relativ zu den untersuchten Substraten stabil ist. Die Meßtischanordnung soll für Auflicht- oder auch Durchlicht-Bearbeitung von Substraten mit unterschiedlichen Gewichten in z.B. Koordinaten-Meßmaschinen oder Wafer-Steppern geeignet sein.

Diese Aufgabe wird erfindungsgemäß mit einer Meßtischanordnung gemäß Anspruch 1 gelöst. Weitere vorteilhafte Weiterbildungen der Erfindung sind Gegenstand der abhängigen Ansprüche

Der Vorteil der Anordnung besteht darin, daß sich der Meßtisch, der Spiegelkörper und die Aufnahme für das Substrat nur an den Auflagepunkten berühren und das Gewicht des Substrats über die übereinander angeordneten Auflagepunkte direkt senkrecht auf den Meßtisch abgestützt wird, ohne den Spiegelkörper zu belasten. Je zwei übereinander angeordnete Auflagepunkte definieren eine senkrechte Achse, über die das aufgelegte Gewicht auf den Meßtisch abgetragen wird. Dadurch wird der Spiegelkörper durch das Auflegen des Substrats bzw. einer Aufnahme für das Substrat auch nicht verzogen, wodurch die Geometrie der Meßspiegel durch unterschiedliche Gewichte verschiedener Substrate unbeeinflußt bleibt.

Auch die Deformationen des Meßtischs, die durch thermische Schwankungen oder beim Verfahren des Meßtischs verursacht werden, haben keinerlei Einfluß auf den Spiegelkörper und damit auf die Meßspiegel und deren Geometrie. Weil das auf die oberen Auflagepunkte aufgelegte Substrat oder die alternativ dort aufgelegte Aufnahme für das Substrat den Spiegelkörper nicht vollflächig, sondern nur an diesen oberen Auflagepunkten berühren, wirken sich thermische Unterschiede zwischen Substrat und Spiegelkörper ebenfalls nicht auf die Meßspiegel aus.

In einer vorteilhaften Ausführungsform der erfindungsgemäßen Meßtischanordnung ist der Spiegelkörper in einem Stück aus einem Material mit extrem niedrigem Ausdehnungskoeffizienten gefertigt ist, und die beiden Meßspiegel sind in seine Außenseiten integriert. Die Meßspiegel können auf verschiedene Weise in den Spiegelkörper integriert sein. Eine Möglichkeit besteht darin, die Meßspiegel separat als dünne Spiegelflächen-Elemente anzufertigen. Sie bestehen dann aus einer dünnen Basisfläche, auf die der eigentliche Meßspiegel aufgedampft ist. Die Spiegelflächen-Elemente werden an den Außenseiten des Spiegelkörpers befestigt. Dies kann beispielsweise durch Aufkleben geschehen. Allerdings besteht bei jeder Art der Befestigung das Problem, daß die Spiegelflächen-Elemente geringfügig verspannt oder verbogen werden könnten. Um thermische Verspannungen zu vermeiden, erweist es sich als vorteilhaft, wenn die Basisfläche der Spiegelflächen-Elemente aus demselben Material wie das des Spiegelkörpers besteht.

Die beste Möglichkeit, die Meßspiegel in den Spiegelkörper zu integrieren, besteht darin, die Meßspiegel direkt auf die Außenseiten des Spiegelkörpers aufzudampfen. Dies hat gegenüber der vorgenannten Methode den Vorteil, daß die Meßspiegel nicht durch nachträgliches Befestigen verbogen oder verspannt werden.

Wenn die Oberfläche des Spiegelkörpers ausreichend glatt ist, kann der Meßspiegel direkt und in einer Aufdampfschicht auf die Außenseite des Spiegelkörpers aufgebracht werden. Sollte dagegen die Oberfläche des Spiegelkörpers Unebenheiten, wie z.B. Poren, feine Kratzer oder ähnliches, aufweisen, muß der Meßspiegel in mehreren Aufdampfschichten aufgebracht werden. Dann wird zunächst eine Unterlage für den eigentlichen Spiegel aufgedampft und danach geebnet, z.B. durch Läppen oder andere hochwertige Verfahren zur Oberflächenbearbeitung. Nach dem Läppen ist die Unterlage optimal geebnet und für weitere Aufdampfschichten vorbereitet. Dann wird der eigentliche Meßspiegel aufgedampft.

Unabhängig davon, ob der Meßspiegel in einer oder mehreren Schichten aufgedampft wird, muß die Unterlage für die Aufdampfschichten möglichst optimal eben sein. Die besten Ergebnisse werden beim Läppen des Spiegelkörpers oder einer unteren Aufdampfschicht erzielt, wenn die geläppte Fläche möglichst breit ist. In der Mitte ist sie dann optimal eben und zu den Rändern, fertigungstechnisch bedingt, etwas abfallend. Daher sollten die Außenflächen des Spiegelkörpers ausreichend hoch sein, um eine optimale Flächenbearbeitung zu ermöglichen, die eine breite, ebene Fläche für die Meßspiegel liefert. Wenn aber der Spiegelkörper wegen der erforderlichen hohen Außenkanten insgesamt sehr dick gewählt wird, wird er zu schwer. Außerdem sind Materialien mit extrem niedrigem Ausdehnungskoeffizienten sehr teuer.

Daher weist in einer besonders vorteilhaften Ausführungsform der erfindungs-gemäßen Meßtischanordnung weist der Spiegelkörper an seiner Oberfläche an drei Seiten eine Randerhöhung mit einer besonders großen, ebenen Außenfläche zur Integration der Meßspiegel auf. Durch die Randerhöhungen wird an der Oberseite des Spiegelkörpers eine einseitig offene, wannenförmige Vertiefung gebildet, in welche das Substrat aus Richtung der offenen Seite eingeschoben und auf den oberen Auflagepunkten aufgelegt werden kann. Diese Ausführungsform hat den Vorteil, daß große Außenseiten mit optimal ebenen Spiegelflächen bei minimalem Materialeinsatz möglich sind.

In einer vorteilhaften Ausführungsform sind drei Bolzen, die nach oben und unten überstehen, senkrecht und spannungsfrei in den Spiegelkörper eingefügt und fest mit ihm verbunden. Die Bolzen nehmen zwei Funktionen wahr. Zum einen stützt sich der mit den Bolzen verbundene Spiegelkörper mittels der unteren Enden der Bolzen auf dem Meßtisch ab. Zum anderen liegt auf den oberen Enden der Bolzen eine Aufnahme für ein Substrat oder ein Substrat direkt auf und stützt sich damit ebenfalls auf dem Meßtisch ab, ohne den Spiegelkörper zu berühren oder zu verspannen.

Die Bolzen sind aus einem Material mit extrem niedrigem Ausdehnungskoeffizienten gefertigt. Sie werden senkrecht und spannungfrei in den Spiegelkörper eingefügt und fest mit diesem verbunden, beispielsweise eingepaßt oder eingeklebt. Sie können aber auch bereits bei der Herstellung des Spiegelkörpers eingesintert werden. Die gesinterte Verbindung hat dabei den Vorteil, daß sie mit Sicherheit unelastisch ist. Beim Kleben wird durch Auswahl eines sehr hart austrocknenden Klebers eine unelastische Verbindung gewährleistet. Vorzugsweise werden zylindrische Bolzen verwendet, weil sie sich am einfachsten spannungsfrei einpassen lassen.

In einer vorteilhaften Ausführungsform sind die Bolzen im Bereich unterhalb des Spiegelkörpers mit einer Verbreiterung als Auflage für den Spiegelkörper ausgestattet. Damit ist, beispielsweise beim Zusammenfügen, ein Anschlag gegeben, der den Spiegelkörper gegen Herabfallen sichert. Beim Sintem könnte diese Verbreiterung von unten in den Spiegelkörper eingelassen werden, um die Verbindungsflächen für den Sintervorgang möglichst groß zu gestalten.

Die oberen Enden der Bolzen wie auch die unteren Enden der Bolzen besitzen vorzugsweise als Abschluß eine Kugelfläche, um eine möglichst ideale Drei-Punkt-Auflage zu erzielen. Da die Kugelflächen einer gewissen Abnutzung unterliegen, müßten nach einiger Zeit die Bolzen oder sogar der Spiegelkörper ausgetauscht werden, was ziemlich aufwendig und teuer ist. Daher weisen in einer vorteilhaften Ausführungsform die oberen Enden der Bolzen bzw. die unteren Enden der Bolzen als Abschluß eine Kegelsenkung auf, in die eine Kugel eingeklebt ist. Diese Kugel kann bei Abnutzung leicht und kostengünstig ausgewechselt werden.

Um eine sichere Positionierung des Spiegelkörpers auf dem Meßtisch zu gewährleisten, ist die Oberfläche des Meßtisches zur Aufnahme einer oder mehrerer der unteren Enden der Bolzen mit Vertiefungen ausgestattet. Diese Vertiefungen dürfen jedoch keine Verspannung des Spiegelkörpers bewirken, um die Spiegelgeometrie nicht zu beeinflussen.

In einer weiteren vorteilhaften Ausführungsform der erfindungsgemäßen Meßtischanordnung sind daher in der Oberfläche des Meßtischs verschiedene Vertiefungen für die unteren Enden der Bolzen vorgesehen, wodurch eine spannungsfreie thermische Ausdehnung des Spiegelkörpers gewährleistet ist. So ist im Randbereich in der Oberfläche des Meßtischs für das untere Ende des ersten Bolzens eine Kegelsenkung eingearbeitet, in welche die Kugelfläche des ersten Bolzens paßgenau eingreift. Damit ist der erste Bolzen an der Position der Kegelsenkung fixiert.

Für das untere Ende des zweiten Bolzens ist eine zu einer Außenkante des Meßtischs parallele, V-förmige Nut in die Oberfläche des Meßtischs eingelassen, deren Längsrichtung auf einer Linie mit der Kegelsenkung liegt. Die in diese V-Nut eingreifende Kugelfläche des zweiten Bolzens wird bei thermischer Ausdehnung des Spiegelkörpers in dieser Nut spannungsfrei zwangsgeführt. Die Kugelfläche des dritten Bolzens bewegt sich dabei frei auf einer ebenen Gleitfläche, um keine Verspannung des Spiegelkörpers zu erzeugen.

Wegen der Fixierung des ersten Bolzens in der Kegelsenkung bleibt die Orientierung des Spiegelkörpers zu dem Meßtisch erhalten, d.h. die Außenkanten des Spiegelkörpers und des Meßtischs bleiben auch bei thermischer Ausdehnung des Spiegelkörpers stets parallel. Damit bilden die Kegelsenkung, die V-Nut und die plane Gleitfläche für die Drei-Punktlagerung des Spiegelkörpers eine spannungsfreie Zwangsführung bei thermischer Ausdehnung des Spiegelkörpers bzw. des Meßtischs relativ zu einander.

Es ist auch möglich, diese spannungsfreie Zwangsführung an den unteren Enden der in den Spiegelkörper eingefügten Bolzen anzubringen. In dieser Ausführungsform sind in den Meßtisch unterhalb der Bolzen drei Kegelsenkungen eingelassen, in die drei Kugeln eingelegt oder eingeklebt sind. Jeweils ein unteres Ende der drei in den Spiegelkörper eingepaßten Bolzen weist eine Kegelsenkung, eine V-Nut und eine ebene Gleitfläche auf, welche auf der Oberseite der Kugeln aufliegen und eine spannungsfreie, zwangsgeführte thermische Ausdehnung bzw. Kontraktion des Spiegelkörpers und des Meßtisches relativ zu einander erlauben.

In einer weiteren Ausführungsform ist der Spiegelkörper nicht mit Bolzen ausgestattet. Statt dessen sind drei Bolzen in die Oberfläche des Meßtischs eingelassen bzw. an seiner Oberfläche angeformt. Den drei Bolzen gegenüberliegend weist die Unterseite des Spiegelkörpers drei Hohlräume auf, in welche die Bolzen klemmfrei eingreifen. Um den Spiegelkörper exakt, aber zugleich spannungsfrei auflegen zu können, weist der erste Bolzen an seinem oberen Ende eine Kegelsenkung und an dem oberen Ende seines zweiten Bolzens eine V-Nut in Richtung der Kegelsenkung auf. Das obere Ende des dritten Bolzens weist eine plane Gleitfläche auf. Die Kegelsenkung, die V-Nut und die Gleitfläche dienen dazu, die unteren Auflagepunkte des Spiegelkörpers aufzunehmen und eine spannungsfreie Lagerung des Spiegelkörpers vorzunehmen.

Die unteren Auflagepunkte, d.h. die Auflagepunkte an der Unterseite des Spiegelkörpers, können in verschiedenen Ausgestaltungen realisiert werden.

In einem Beispiel sind die Hohlräume im Spiegelkörper sehr weit bis in die Nähe der Oberfläche des Spiegelkörpers eingelassen. Oberhalb der Hohlräume sind Kugeln in den Spiegelkörper eingepaßt, die nach oben über seine Oberseite hinaus und nach unten in die Hohlräume ragen. Die Unterseiten der Kugeln bilden die unteren Auflagepunkte und liegen in der Kegelsenkung, in der V-Nut und auf der planen Gleitfläche der drei Bolzen auf. Dadurch stützt sich der Spiegelkörper mit diesen unteren Auflagepunkten lediglich auf den Bolzen des Meßtischs ab, ohne die Oberfläche des Meßtischs zu berühren. Damit werden weder thermische Schwankungen noch mechanische Verspannungen des Meßtischs auf den Spiegelkörper und die Spiegelgeometrie übertragen. Gleichzeitig bilden die über die Oberfläche des Spiegelkörpers hinausragenden Oberseiten der Kugeln die oberen Auflagepunkte, auf die ein zu vermessendes Substrat oder eine Aufnahme für ein Substrat aufgelegt wird.

Es ist auch denkbar, anstelle der Kugeln drei kurze Bolzen mit halbkugelförmigen Enden an der Oberseite des Spiegelkörpers einzupassen. Die oberen Enden der Bolzen ragen dann über die Oberfläche des Spiegelkörpers hinaus und bilden die oberen Auflagepunkte. Die unteren Enden ragen von oben in die Hohlräume des Spiegelkörpers und bilden die unteren Auflagepunkte, welche den Spiegelkörper spannungsfrei über die Kegelsenkung, die V-Nut und die Gleitfläche der drei Bolzen auf den Meßtisch abstützen.

In einer anderen Ausführungsform sind die Hohlräume nicht so weit in den Spiegelkörper hineingeführt. Dies hat den Vorteil, daß oberhalb der Hohlräume der Spiegelkörper eine größere Materialstärke aufweist. Damit wird eine größere Verwindungs-Steifigkeit des gesamten Spiegelkörpers erzielt.

Um erfindungsgemäß untere Auflagepunkte mit einer spannungsfreien Zwangsführung zu schaffen, sind an den oberen Enden der drei Hohlräume Kegelsenkungen eingelassen, in welche drei Kugeln einfügt sind. Diese drei Kugeln bilden in Richtung der Bolzen die unteren Auflagepunkte und stützen sich auf die drei Bolzen ab, von denen je einer am oberen Ende eine Kegelsenkung, eine V-Nut und eine Gleitfläche aufweist.

Alternativ kann die spannungsfreie Zwangsführung auch erzielt werden, indem an den oberen Enden der drei Hohlräume je eine Kegelsenkung, eine V-Nut und eine Gleitfläche vorgesehen sind. Die darunter befindlichen Bolzen sind an ihren oberen Enden mit Kegelsenkungen versehen, in welche drei Kugeln eingelegt sind. Auf die Kugeln stützen sich die Kegelsenkung, die V-Nut und die Gleitfläche ab und ermöglichen eine spannungsfreie, zwangsgeführte relative Ausdehnung bzw. Kontraktion des Meßtischs gegenüber dem Spiegelkörper.

Die oberen Auflagepunkte bilden drei Halbkugeln, die an der Oberfläche des Spiegelkörpers oberhalb der Hohlräume angebracht sind. Sie können dazu beispielsweise aufgeklebt oder angesintert sein. Auf die Oberseite der Halbkugeln wird die Aufnahme für ein zu vermessendes Substrat aufgelegt.

Der erfindungsgemäße Meßtisch kann in einer besonders vorteilhaften Ausführungsform universell für Auflicht- als auch Durchlicht-Anwendungen eingesetzt werden, beispielweise für Koordinaten-Meßmaschinen als auch für Wafer-Stepper. Dazu weisen der Meßtisch, der Spiegelkörper und der Substrathalter in der Mitte jeweils übereinanderliegende, rahmenförmige Öffnungen auf, so daß das Substrat von unten und oben und damit gleichermaßen für Auflicht- und Durchlicht-Anwendungen zugänglich ist. Für den Spiegelkörper ergibt sich durch das wegen der Öffnung eingesparte Material eine Gewichts- und Kostenreduktion.

Die Erfindung wird anhand von Ausführungsbeispielen mithilfe der schematischen Zeichnung näher erläutert. Es zeigen:
- ***Fig. 1:***: Schnitt durch eine erfindungsgemäße Meßtischanordnung in einer Koordinaten-Meßmaschine für Auflicht- und Durchlichtbeleuchtung;
- ***Fig. 2:***: Aufsicht eines Ausführungsbeispiels einer erfindungsgemäßen Meßtischanordnung für Auflicht-Anwendungen;
- ***Fig. 3:***: Schnitt durch ein erstes Ausführungsbeispiel einer erfindungsgemäßen Meßtischanordnung für Auflicht-Anwendungen;
- ***Fig. 4:***: Schnitt durch ein zweites Ausführungsbeispiel einer erfindungsgemäßen Meßtischanordnung für Auflicht- und Durchlicht-Anwendungen;
- ***Fig. 5:***: Schnitt durch ein drittes Ausführungsbeispiel einer erfindungsgemäßen Meßtischanordnung für Auflicht- und Durchlicht-Anwendungen;
- ***Fig. 6:***: Schnitt durch ein viertes Ausführungsbeispiel einer erfindungsgemäßen Meßtischanordnung für Auflicht- und Durchlicht-Anwendungen.

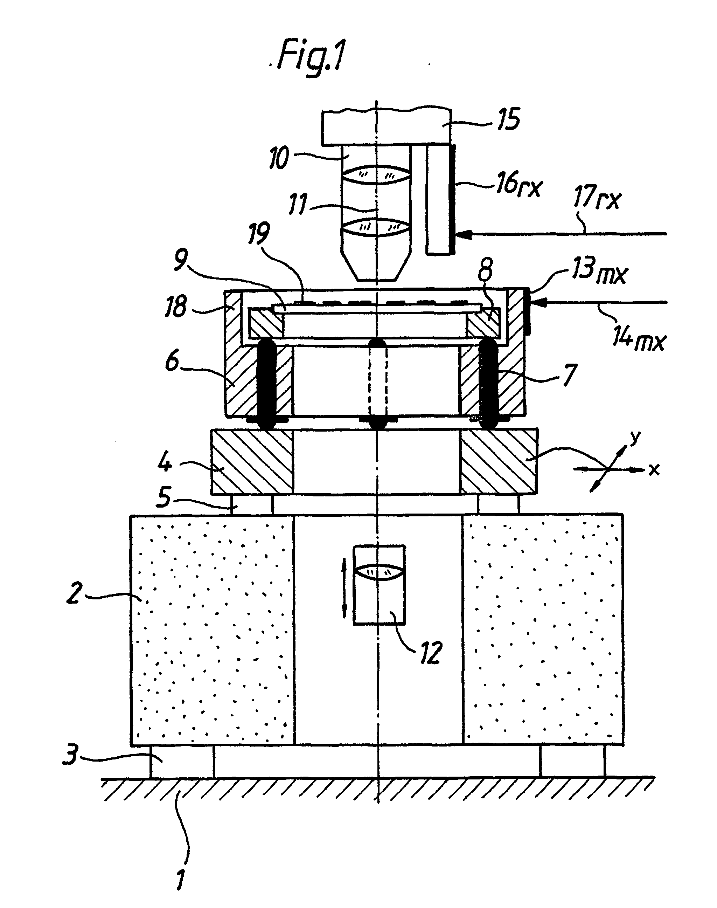

In ***Fig. 1*** steht auf einem Untergrund 1 ein Granitblock 2, der mittels Luftfedern 3 gegen Schwingungen des Untergrundes 1 isoliert ist. Ein Meßtisch 4 stützt sich auf Luftlagern 5 auf dem Granitblock 2 ab. Der Meßtisch 4 ist horizontal in zwei zueinander senkrechten Richtungen, hier als x- und y- Achse angedeutet, verschiebbar. Die Antriebe zur Erzielung der Verschiebung sind hier nicht dargestellt.

Durch einen Spiegelkörper 6 sind senkrecht drei Bolzen 7 mit abgerundeten Enden spannungsfrei hindurchgeführt, die nach oben und unten überstehen. Mittels der Bolzen 7 stützt sich der Spiegelkörper 6 auf dem Meßtisch 4 ab. Die Bolzen 7 sind so angeordnet, daß sie eine stabile Drei-Punkt-Auflage des Spiegelkörpers 6 auf dem Meßtisch 4 bewirken, hier also zwei Bolzen links und rechts vorne in der Schnittebene, der dritte Bolzen hinten in der Mitte. Um die Aufstandsfläche optimal klein zu halten, sind die unteren Enden der Bolzen 7 als Kugelfläche gestaltet.

Die Bolzen 7 weisen unterhalb des Spiegelkörpers 6 eine Verbreiterung auf, die als Auflage für den Spiegelkörper 6 dient und beim Einpassen der Bolzen 7 in den Spiegelkörper 6 das Herabfallen des Spiegelkörpers 6 verhindert. Die Bolzen 7 sind in dem dargestellten Beispiel vorgefertigt und nachträglich in den Spiegelkörper 6 eingeklebt worden. Die Klebeschicht ist nicht dargestellt. Für die Klebeverbindung eignen sich solche Kleber, die sehr hart und unelastisch aushärten und damit eine möglichst unelastische Klebeverbindung liefern.

Der Spiegelkörper 6 besteht aus einem Material mit extrem niedrigem Ausdehnungskoeffizienten und ist aus einem einzigen Stück gefertigt. Damit unterliegt seine Geometrie nur geringsten thermischen Schwankungen. Die Bolzen 7 sind ebenfalls aus einem Material mit extrem niedrigem Ausdehnungskoeffizienten gefertigt, und zwar vorzugsweise aus dem selben Material wie der Spiegelkörper 6. Damit ist gewährleistet, daß sich der Spiegelkörper 6 und die Bolzen 7 bei thermischer Ausdehnung nicht verspannen. Auf den oberen Enden der Bolzen 7 liegt eine Aufnahme 8 mit einer rahmenförmigen Vertiefung auf, in die ein Substrat 9 mit Strukturen 19 aufgelegt ist. Es ist auch möglich, das Substrat 9 direkt auf die Bolzen 7 aufzulegen.

In den Spiegelkörper 6 sind die beiden Meßspiegel 13ₘₓ,13_{my} (letzterer ist nicht dargestellt) für die interferometrische Positionsbestimmung in der x- und der y-Achse des Meßtischs 4 integriert. In diesem Beispiel sind sie direkt auf das Material des Spiegelkörpers 6 aufgedampft.

Weil der Spiegelkörper 6 mittels der drei Bolzen 7 auf dem Meßtisch 4 gelagert ist, sind die integrierten Meßspiegel 13ₘₓ, 13_{my} zugleich von dem Substrat 9 als auch von dem Meßtisch 4 körperlich und damit auch thermisch getrennt angeordnet. Durch die gleichzeitig mittels der oberen Enden der Bolzen 7 erzielte Drei-Punkt-Lagerung des Substrats 9 bzw. der Aufnahme 8 auf dem Meßtisch, wirkt das Gewicht der aufgelegten Substrate 9 und der Aufnahme 8 ausschließlich auf den Meßtisch 4, jedoch nicht auf den Spiegelkörper 6 und die Spiegelgeometrie.

Der Spiegelkörper 6 weist in der hier dargestellten vorteilhaften Ausführungsform an der linken, der rechten und der vom Betrachter abgewendeten Seite eine Randerhöhung 18 auf. An der Außenseite der rechten Randerhöhung 18 ist in den Spiegelkörper 6 ein Meßspiegel 13ₘₓ für die x-Achse integriert. Auf den Meßspiegel 13ₘₓ ist ein der x-Achse zugeordneter Interferometer-Meßstrahl 14ₘₓ gerichtet, der zur interferometrischen Bestimmung der x-Position des Meßtischs 4 dient. An der Außenseite der rückwärtigen Randerhöhung 18 des Spiegelkörpers 6 ist ein (hier nicht dargestellter) Meßspiegel 13_{my} integriert. Auf diesen ist ein der y-Achse zugeordneter (ebenfalls nicht dargestellter) Interferometer-Meßstrahlengang 14_{my} gerichtet, der zur interferometrischen Bestimmung der y-Position des Meßtischs 4 dient.

Ein Objektiv 10 mit einer optischen Achse 11 ist auf die Oberfläche des Substrats 9 gerichtet. Unterhalb des Substrats 9 ist auf der optischen Achse 11 ein Kondensor 12 verschiebbar angeordnet, der bei Bedarf eine Durchlichtbeleuchtung erzeugt. Um diese Durchlichtbeleuchtung zu ermöglichen, sind der Granitblock 2, der Meßtisch 4, der Spiegelkörper 6 und die Aufnahme 8 mit rahmenförmigen Öffnungen um die optische Achse 11 ausgestattet.

An dem Stativ 15, an dem das Objektiv 10 angebracht ist, ist ein Referenzspiegel 16ᵣₓ für die interferometrische x-Positionsbestimmung des Meßtischs 4 befestigt. Er befindet sich in einem starren Abstand zu der optischen Achse 11 des Objektivs 10. Auch für die interferometrische Positionbestimmung der y-Achse ist ein Refenzspiegel (16_{ry}) angebracht, der in dieser Figur nicht dargestellt ist.

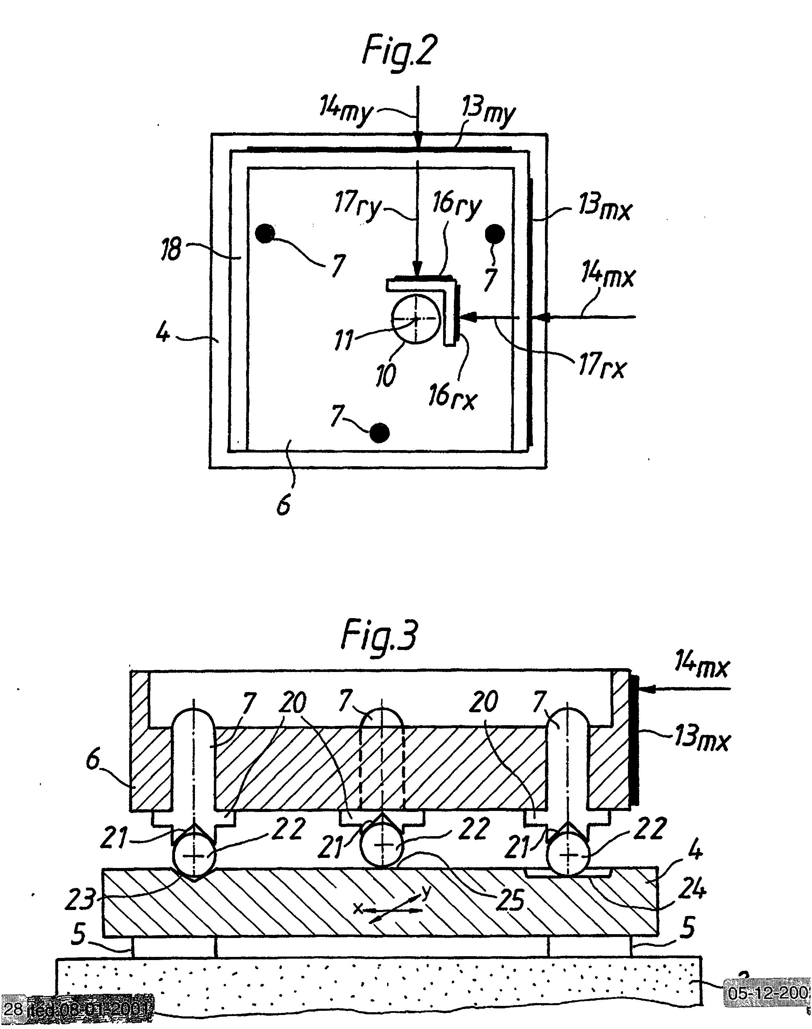

***Fig. 2*** zeigt einen Meßtisch 4 mit einem Spiegelkörper 6 in der Aufsicht. Der Spiegelkörper 6 ist mit einer an drei Seiten umlaufenden Randerhöhung 18 ausgebildet. Zur Erzielung einer Drei-Punkt-Auflage auf dem Meßtisch 4 sind drei Bolzen 7 spannungsfrei durch den Spiegelkörper 6 hindurchgeführt und fest mit ihm verbunden. Auf die Bolzen 7 kann eine Aufnahme für ein Substrat aufgelegt werden (hier nicht dargestellt).

An zwei zueinander senkrechten Seiten sind zwei Meßspiegel 13ₘₓ, 13_{my} in den Spiegelkörper 6 integriert, z.B. direkt auf ihn aufgedampft. Für einen Interferometer-Meßstrahlengang 14ₘₓ für die Positionsbestimmung der x-Achse ist der Meßspiegel 13ₘₓ und für einen Interferometer-Meßstrahlengang 14_{my} für die Positionsbestimmung der y-Achse ist der Meßspiegel 13_{my} angeordnet.

Jedem Interferometer-Meßstrahlengang 14ₘₓ, 14_{my} ist jeweils ein Referenzspiegel 16ᵣₓ bzw. 16_{ry} zugeordnet. Diese sind in der Nähe und in festem Abstand zu dem Objektiv 10 und dessen optischer Achse 11 angeordnet. Auf den Referenzspiegel 16ᵣₓ ist ein Referenzstrahlengang 17ᵣₓ für die x-Achse und auf den Referenzspiegel 16_{ry} ist ein Referenzstrahlengang 17_{ry} für die y-Achse gerichtet.

Der Meßtisch 4 ist gegenüber der optischen Achse 11 verschoben dargestellt. Daher treffen auch die Interferometer-Meßstrahlengänge 14ₘₓ, 14_{my} die Meßspiegel 13ₘₓ 13_{my} nicht in der Mitte, sondern etwas seitlich versetzt. Um eine Positionsmessung über die gesamte, von den Bolzen 7 definierte Auflagefläche des Spiegelkörpers 6 zu ermöglichen, sind die Meßspiegel 13ₘₓ, 13_{my} an den Außenseiten des Spiegelkörpers 6 mindestens so lang wie die maximale Meßstrecke in der betreffenden Richtung bzw. wie der maximale Verfahrbereich des Meßtischs 4 gewählt.

***Fig. 3*** zeigt einen Schnitt durch ein Ausführungsbeispiel mit Meßtisch 4, der für Auflicht-Anwendungen geeignet ist und eine besonders vorteilhafte Ausgestaltung der Bolzen 7 aufweist.

Dargestellt ist ein in der x- und der y-Richtung verschiebbarer Meßtisch 4, der sich mithilfe von Luftlagem 5 auf einem Granitblock 2 abstützt. Ein Spiegelkörper 6 mit einem seitlich angebrachten Meßspiegel 13ₘₓ für einen auftreffenden Interferometer-Meßstrahl 14ₘₓ steht mittels dreier eingefügter Bolzen 7 auf dem Meßtisch 4. Die Bolzen weisen unterhalb des Spiegelkörpers 6 jeweils Verbreiterungen als Auflager 20 auf. Die unteren Enden der Bolzen 7 sind mit einer Kegelsenkung 21 ausgestattet, in die jeweils eine Kugel 22 eingelegt oder eingeklebt ist.

Für die beiden vorderen Bolzen 7, die rechts und links in der Schnittebene liegen, sind in der Oberfläche des Meßtischs 4 Vertiefungen zur Aufnahme der Kugeln 22 eingelassen. Die Kugel 22 des linken Bolzens 7 liegt in einer Kegelsenkung 23 im Randbereich des Meßtischs 4 und ist damit auf diese Position fixiert.

Die Kugel 22 des rechten Bolzens 7 liegt in einer V-Nut 24 des Meßtischs 4, die in Richtung der Kegelsenkung 23 weist und zugleich parallel zu einer Außenkante des Meßtischs 4 und damit auch parallel zu einer Außenkante des Spiegelkörpers 6 ausgerichtet ist. Wenn sich der Spiegelkörper 6 infolge thermischer Schwankungen geringfügig ausdehnen oder zusammenziehen sollte, dann wird diese Kugel 22 in der V-Nut 24 zwangsgeführt, kann sich jedoch in Längsrichtung der V-Nut frei bewegen. Damit bleiben die Außenkanten des Spiegelkörpers 6 auch bei Volumenänderungen aufgrund thermischer Schwankungen stets optimal parallel zu den Außenkanten des Meßtischs 4 orientiert.

Der dritte Bolzen 7, der in der Mitte weiter hinten angeordnet ist, darf keiner Zwangsführung unterworfen werden, um Verspannungen des Spiegelkörpers 6 zu vermeiden. Für ihn ist deshalb keine Vertiefung in den Meßtisch 4 eingelassen. Dieser mittlere Bolzen 7 ist entsprechend etwas kürzer als die beiden anderen Bolzen 7 und gleitet auf einer ebenen Gleitfläche 25 des Meßtischs 4. Um die Gleiteigenschaften zu verbessern, kann noch eine spezielle Gleitfläche in den Meßtisch 4 eingelassen werden, was hier aber nicht dargestellt ist. Die Kegelsenkung 21, die V-Nut 24 und die ebene Gleitfläche 25 bewirken gemeinsam eine spannungsfreie, zwangsgeführte Lagerung, die bei thermischer Ausdehnung des Meßtischs 4 oder des Spiegelkörpers 6 deren Außenkanten stets parallel zueinander hält.

Es ist alternativ auch möglich, anstelle der V-Nut 24 und der Gleitfläche 25 ebenfalls Kegelsenkungen in die Oberfläche des Meßtisches 4 einzulassen und die Kugeln 22 in diesen drei Kegelsenkungen des Meßtisches 4 ortsfest zu lagern. Dann wird die spannungsfreie Zwangsführung an den unteren Enden der Bolzen 7 realisiert. Dazu wird je ein Bolzen am unteren Ende mit einer Kegelsenkung, einer V-Nut und einer planen Gleitfläche versehen, welche sich auf die Kugeln 22 abstützen und eine spannungsfreie, zwangsgeführte Ausdehnung von Meßtisch 4 bzw. Spiegelkörper 6 gewährleisten.

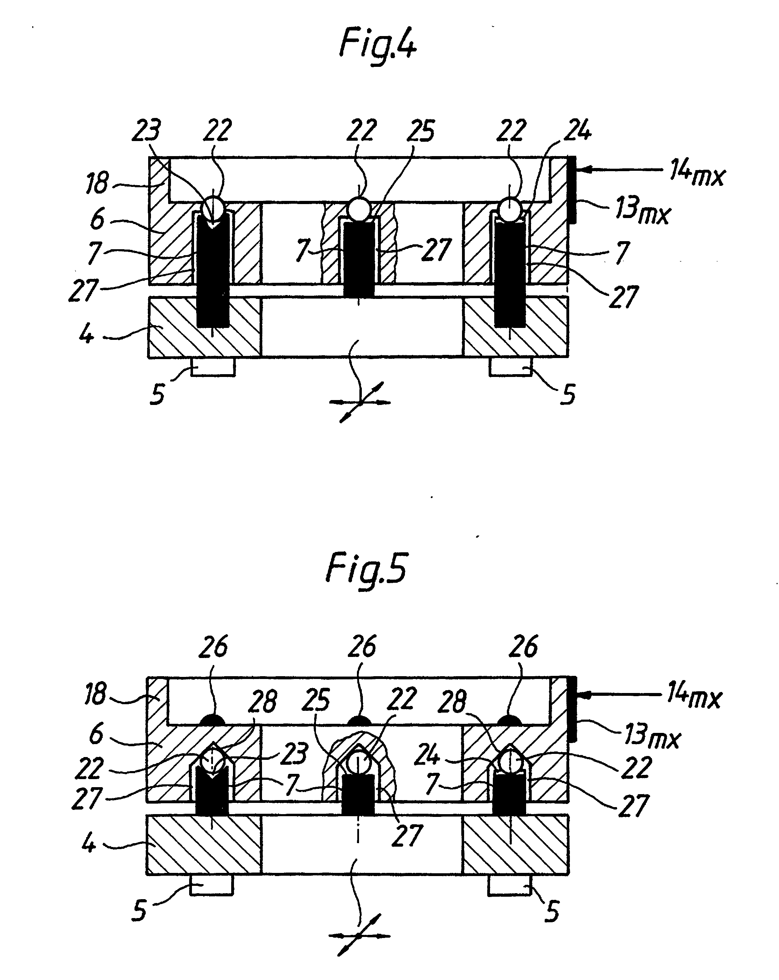

***Fig.4*** zeigt einen Schnitt durch ein zweites Ausführungsbeispiel einer erfindungsgemäßen Meßtischanordnung, die in dieser Ausführungsform sowohl für Auflichtals auch Durchlicht-Anwendungen geeignet ist.

Dargestellt ist ein rahmenförmiger Meßtisch 4, der auf Luftlagern 5 ruht. In die Oberfläche des Meßtischs 4 eingepaßt sind drei senkrecht nach oben überstehende Bolzen 7. Das obere Ende des ersten Bolzens 7 weist eine Kegelsenkung 23 auf. Das obere Ende des zweiten Bolzens 7 weist eine V-Nut 24 auf, deren Längsrichtung auf einer Linie mit der Kegelsenkung 23 liegt. Das obere Ende des dritten Bolzens 7 besitzt eine plane Gleitfläche 25.

Oberhalb des Meßtischs 4 ist ein Spiegelkörper 6 mit rahmenförmiger Öffnung angeordnet, der an der linken und rechten Außenseite sowie an der Rückseite eine Randerhöhung 18 aufweist. An der rechten Seite des Spiegelkörpers 6 ist für einen die x-Koordinate messenden Interferometer-Meßstrahl 14ₘₓ ein Meßspiegel 13ₘₓ angebracht. Der Meßspiegel und der Interferometer-Meßstrahl für die y-Koordinate sind hier nicht dargestellt.

Die drei Bolzen 7 des Meßtischs 4 ragen klemmfrei in drei Hohlräume 27, die senkrecht in die Unterseite des Spiegelkörpers 6 eingelassen sind. Oberhalb der Hohlräume 27 sind in den Spiegelkörper 6 drei Kugeln 22 eingepaßt, z.B. eingesintert. Die Kugeln 22 ragen nach oben über die Oberseite des Spiegelkörpers 6 hinaus und nach unten in die oberen Enden der Hohlräume 27 hinein. Die Oberseite und die Unterseite der Kugeln 22 bilden erfindungsgemäß die benötigten oberen und unteren Auflagepunkte. Der Spiegelkörper 6 stützt sich dabei mittels der Unterseite der Kugeln 22 auf der Kegelsenkung 23, der V-Nut 24 und der planen Gleitfläche 25 der Bolzen 7 ab, die eine spannungsfreie Zwangsführung der Kugel 22 bei thermischer Ausdehnung des Meßtisch 4 bewirken.

Auf die Oberseite der Kugeln 22 kann eine Aufnahme für eine Substrat oder ein Substrat direkt aufgelegt werden, wobei eine Verspannung des Spiegelkörpers 6 und eine Beeinflussung der Spiegelgeometrie ausgeschlossen ist. Der Interferometer-Meßstrahl 14ₘₓ muß dabei stets in derselben Ebene liegen wie die zu messenden Strukturen des Substrats. Die rahmenförmigen Öffnungen des Meßtischs 4 und des Spiegelkörpers 6 liegen übereinander, so daß das Substrat von unten und oben und damit gleichermaßen für Auflicht- und Durchlicht-Anwendungen zugänglich ist.

***Fig.5*** zeigt einen Schnitt durch ein weiteres Ausführungsbeispiel einer erfindungsgemäßen Meßtischanordnung, die sowohl für Auflicht- als auch Durchlicht-Anwendungen geeignet ist. Dargestellt ist ein rahmenförmiger Meßtisch 4, der auf Luftlagern 5 ruht. Oberhalb des Meßtischs 4 ist ein ebenfalls rahmenförmiger Spiegelkörper 6 angeordnet, der an der linken und rechten Außenseite sowie an der Rückseite eine Randerhöhung 18 aufweist. An der rechten Seite des Spiegelkörpers 6 ist für einen die x-Koordinate messenden Interferometer-Meßstrahl 14ₘₓ ein Meßspiegel 13ₘₓ angebracht. Der Meßspiegel und der Interferometer-Meßstrahl für die y-Koordinate sind nicht dargestellt.

An den Meßtisch 4 sind an seiner Oberseite drei senkrecht nach oben überstehende Bolzen 7 angeformt oder angesintert. Das obere Ende des ersten Bolzens 7 weist eine Kegelsenkung 23 und das obere Ende des zweiten Bolzens 7 eine V-Nut 24 auf, welche in Richtung der Kegelsenkung 23 weist und parallel zu einer Außenkante des Meßtischs 4 orientiert ist. Das obere Ende des dritten Bolzens 7 ist mit einer planen Gleitfläche 25 ausgestattet.

In der Unterseite des Spiegelkörpers 6 sind zur klemmfreien Aufnahme der Bolzen 7 drei Hohlräume 27 vorgesehen sind, deren obere Endflächen jeweils eine Kegelsenkung 28 aufweisen. In diese Kegelsenkungen 28 sind jeweils Kugeln 22 eingefügt, welche die unteren Auflagepunkte bilden. Sie liegen auf der Kegelsenkung 23, der V-Nut 24 und der planen Gleitfläche 25 auf, welche gemeinsam ein spannungsfreie Zwangsführung der Kugeln 22 bei thermischer Ausdehnung des Meßtisch 4 gegenüber dem Spiegelkörper 6 bewirken, so daß die Außenkanten derselben stets parallel ausgerichtet sind.

An der Oberfläche des Spiegelkörpers 6 sind oberhalb der Kegelsenkungen 28 drei Halbkugeln 26 aufgebracht, welche die oberen Auflagepunkte bilden. Auf diese kann eine Aufnahme für ein Substrat oder ein Substrat direkt aufgelegt werden, ohne den Spiegelkörper 6 zu verspannen und damit die Spiegelgeometrie zu verändern. Indem die rahmenförmigen Öffnungen des Meßtischs 4 und des Spiegelkörpers 6 übereinander liegen, ist das Substrat von unten und oben und damit gleichermaßen für Auflicht- und Durchlicht-Anwendungen zugänglich.

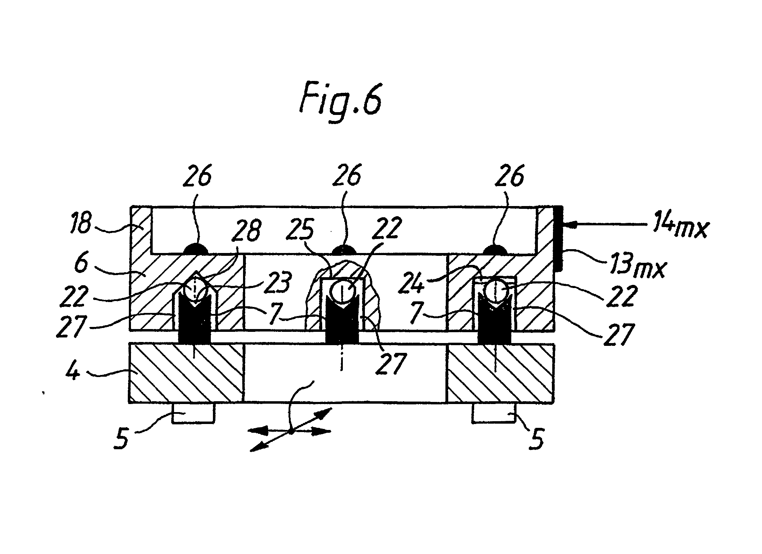

***Fig. 6*** zeigt einen Schnitt durch ein weiteres Ausführungsbeispiel für Auflicht- und Durchlicht-Anwendungen, das sich von dem Ausführungsbeispiel in ***Fig.5*** durch eine andere Ausgestaltung der spannungsfreien Zwangsführung auszeichnet.

Ein rahmenförmiger x/y-verfahrbarer Meßtisch 4 ruht auf Luftlagern 5. An der Oberseite des Meßtischs 4 sind drei senkrecht nach oben stehende Bolzen 7 angeformt. Alle drei Bolzen 7 weisen an ihrem oberen Ende eine Kegelsenkung 23 auf, in die jeweils eine Kugel 22 eingefügt, z.B. eingelegt oder eingeklebt, ist. Auf diese Kugeln 22 stützt sich der Spiegelkörper 6 ab, der über dem Meßtisch 4 angeordnet ist. Dazu sind in die Unterseite des Spiegelkörpers 6 drei Hohlräume 27 zur klemmfreien Aufnahme der Bolzen 7 eingelassen.

Zur Erzielung einer spannungsfreien Zwangsführung der Kugeln 22 sind an den oberen Enden der drei Hohlräume 27 je eine Kegelsenkung 28, eine V-Nut 24 und eine Gleitfläche 25 vorgesehen sind. Die V-Nut 24 weist in Richtung der Kegelsenkung 28 und ist zugleich parallel zu den Außenkanten des Meßtischs 4 und des Spiegelkörpers 6 ausgerichtet.

Bei thermischer Ausdehnung bzw. Kontraktion des Meßtischs 4 relativ zu dem Spiegelkörper 6 können sich die unter der V-Nut 24 und der Gleitfläche 25 befindlichen Kugeln 22 spannungsfrei bewegen, während die Kugel 22 unter der Kegelsenkung 28 ortsfest bleibt. Dadurch bleiben die Außenkanten des Meßtischs 4 und des Spiegelkörpers 6 stets parallel.

An der Oberfläche des Spiegelkörpers 6 sind oberhalb der Hohlräume 27 drei Halbkugeln 26 angeformt, welche die oberen Auflagepunkte bilden. Auf diese kann ein Substrat oder eine Aufnahme für ein Substrat aufgelegt werden, ohne den Spiegelkörper 6 zu verspannen und damit die Spiegelgeometrie zu verändern. Die rahmenförmigen Öffnungen des Meßtischs 4 und des Spiegelkörpers 6 liegen übereinander, so daß das Substrat sowohl von unten als auch von oben und damit gleichermaßen für Auflicht- und Durchlicht-Anwendungen zugänglich ist.

### Bezugszeichenliste

- 1: Untergrund
- 2: Granitblock
- 3: Luftfedern
- 4: Meßtisch
- 5: Luftlager
- 6: Spiegelkörper
- 7: Bolzen
- 8: Aufnahme
- 9: Substrat
- 10: Objektiv
- 11: optische Achse
- 12: Kondensor
- 13: ₘₓ, 13_{my} Meßspiegel für die x- bzw. y-Achse
- 14: _{my}, 14_{my} Interferometer-Meßstrahlengang für die x- bzw. y-Achse
- 15: Stativ
- 16: ᵣₓ, 16_{ry} Referenzspiegel für die x- bzw. y-Achse
- 17: ᵣₓ, 17_{ry} Referenzstrahlengang für die x- bzw. y-Achse
- 18: Randerhöhung
- 19: Strukturen
- 20: Auflager
- 21: Kegelsenkung
- 22: Kugel
- 23: Kegelsenkung
- 24: V-Nut
- 25: plane Gleitfläche
- 26: Halbkugel
- 27: Hohlraum
- 28: Kegelsenkung

## Patentansprüche

1. Meßtischanordnung mit einem verfahrbaren x/y-Koordinaten-Meßtisch (4), mit einer Aufnahme (8) für ein zu vermessendes Substrat (9), mit zwei orthogonal zueinander stehenden Meßspiegeln (13ₘₓ, 13_{my}) als Meßreflektoren eines die x/y-Position messenden Interferometers, und mit einem die Meßspiegel (13ₘₓ, 13_{my}) dragenden Spiegelhörper (6),
**dadurch gekennzeichnet, daß**
der Meßtisch (4) der Spiegelkörper (6) und die Aufnahme (8) für das Substrat (9) als separate Bauelemente ausgeführt sind, wobei der Spiegelkörper (6) in einem von den Meßspiegeln (13ₘₓ, 13_{my}) umrahmten Flächenbereich auf seiner Ober- und Unterseite je drei einander gegenüberliegende Auflagepunkte aufweist, so daß der Spiegelhörper (6) nur mit den unteren Auflagepunkten auf dem Meßtisch (4) aufliegt und nur mit den oberen Auflagepunkten die Aufnahme (8) für das Substrat (9) trägt.

2. Anordnung nach Anspruch 1,
**dadurch gekennzeichnet, daß**
a) in die Oberfläche des Meßtischs (4) drei überstehende senkrechte Bolzen (7) angeformt oder eingepaßt sind, wobei das obere Ende des ersten Bolzens (7) eine Kegelsenkung (23), das obere Ende des zweiten Bolzens (7) eine zu einer Außenkante des Meßtischs (4) parallele V-Nut (24) in Richtung der Kegelsenkung (23) und das obere Ende des dritten Bolzens (7) eine plane Gleitfläche (25) aufweist,
b) in der Unterseite des Spiegelkörpers (6) drei Hohlräume (27) zur klemmfreien Aufnahme der Bolzen (7) vorgesehen sind,
c) und oberhalb der Hohlräume in den Spiegelkörper (6) drei Kugeln (22) oder drei Bolzen mit halbkugelförmigen Enden eingepaßt sind, die nach oben über seine Oberseite hinaus und nach unten in die oberen Enden der Hohlräume (27) ragen und dadurch die Auflagepunkte bilden, wobei sich der Spiegelkörper (6) mittels der Unterseite der Kugeln (22) auf der Kegelsenkung (23), der V-Nut (24) und der planen Gleitfläche der Bolzen (7) abstützt.

3. Anordnung nach Anspruch 1,
**dadurch gekennzeichnet, daß**
a) an der Oberseite des Meßtischs (4) drei senkrechte Bolzen (7) angeformt oder eingepaßt sind, wobei deren obere Enden je eine Kegelsenkung (23), eine zu einer Außenkante des Meßtischs (4) parallele V-Nut (24) in Richtung der Kegelsenkung (23) und eine plane Gleitfläche (25) aufweisen,
b) die Unterseite des Spiegelkörpers (6) zur klemmfreien Aufnahme der Bolzen (7) drei Hohlräume (27) aufweist, in deren obere Enden jeweils eine Kegelsenkung (28) eingelassen ist,
c) unter den Kegelsenkungen (28) drei die unteren Auflagepunkte bildende Kugeln (22) eingefügt sind, die sich auf der Kegelsenkung (23), der V-Nut (24) und der planen Gleitfläche (25) abstützen,
d) und an der Oberfläche des Spiegelkörpers (6) über den Kegelsenkungen (28) der Hohlräume (27) drei Halbkugeln (26) als obere Auflagepunkte angebracht sind.

4. Anordnung nach Anspruch 1,
**dadurch gekennzeichnet, daß**
a) an der Oberseite des Meßtischs (4) drei senkrechte Bolzen (7) angeformt oder eingepaßt sind, deren obere Enden jeweils eine Kegelsenkung (23) aufweisen,
b) die Unterseite des Spiegelkörpers (6) zur klemmfreien Aufnahme der Bolzen (7) drei Hohlräume (27) aufweist, deren obere Enden je eine Kegelsenkung, eine zu einer Außenkante des Meßtischs (4) parallele V-Nut in Richtung dieser Kegelsenkung und eine plane Gleitfläche aufweisen,
c) sich die Kegelsenkung, die V-Nut und die plane Gleitfläche der Hohlräume (27) auf drei die unteren Auflagepunkte bildende Kugeln (22) abstützen, die in die Kegelsenkungen (23) der Bolzen eingefügt sind,
d) und an der Oberfläche des Spiegelkörpers (6) über den Hohlräumen (27) drei Halbkugeln (26) als obere Auflagepunkte angebracht sind.

5. Anordnung nach Anspruch 1,
**dadurch gekennzeichnet, daß**
durch den Spiegelkörper (6) drei nach oben und unten überstehende Bolzen (7) senkrecht und spannungsfrei hindurchgeführt und mit ihm fest verbunden sind, wobei die Enden der Bolzen (7) die oberen und unteren Auflagepunkte bilden.

6. Anordnung nach Anspruch 5,
**dadurch gekennzeichnet, daß**
die Bolzen (7) aus einem Material mit extrem niedrigem Ausdehnungskoeffizienten gefertigt sind.

7. Anordnung nach Anspruch 5,
**dadurch gekennzeichnet, daß**
die oberen Enden der Bolzen (7) eine Kugelfläche als Abschluß besitzen.

8. Anordnung nach Anspruch 5,
**dadurch gekennzeichnet, daß**
die oberen Enden der Bolzen (7) eine Kegelsenkung als Abschluß besitzen, in die eine Kugel eingelegt oder eingeklebt ist.

9. Anordnung nach Anspruch 5,
**dadurch gekennzeichnet, daß**
die unteren Enden der Bolzen eine Kugelfläche als Abschluß besitzen.

10. Anordnung nach Anspruch 9,
**dadurch gekennzeichnet, daß**
die unteren Enden der Bolzen (7) eine Kegelsenkung (21) als Abschluß besitzen, in die eine Kugel (22) eingelegt oder eingeklebt ist.

11. Anordnung nach Anspruch 5,
**dadurch gekennzeichnet, daß**
die Bolzen (7) im Bereich unterhalb des Spiegelkörpers (6) eine Verbreiterung als Auflage (20) für den Spiegelkörper (6) aufweisen.

12. Anordnung nach Anspruch 5,
**dadurch gekennzeichnet, daß**
die Oberfläche des Meßtisches (4) zur Aufnahme einer oder mehrerer der unteren Enden der Bolzen (7) Vertiefungen aufweist.

13. Anordnung nach Anspruch 5,
**dadurch gekennzeichnet, daß**
a) je ein unteres Ende der Bolzen (7) eine Kegelsenkung (21), eine zu einer Außenkante des Meßtischs (4) parallele V-Nut (24) in Richtung der Kegelsenkung (21) und eine ebene Gleitfläche (25) aufweist,
b) und in der Oberfläche des Meßtischs (4) für die drei Bolzen (7) drei Kegelsenkungen (23) vorhanden sind, in die jeweils eine Kugel (22) eingelegt oder eingeklebt ist.

14. Anordnung nach Anspruch 5,
**dadurch gekennzeichnet, daß**
a) alle unteren Enden der Bolzen (7) eine Kegelsenkung (21) als Abschluß besitzen, in die je eine Kugel (22) eingelegt oder eingeklebt ist,
b) und in der Oberfläche des Meßtischs (4) für die erste Kugel (22) eine Kegelsenkung (23), für die zweite Kugel (22) eine zu einer Außenkante des Meßtischs (4) parallele V-Nut (24) in Richtung der Kegelsenkung (23) und für die dritte Kugel (22) eine ebene Gleitfläche (25) vorhanden ist.

15. Anordnung nach Anspruch 1-5,
**dadurch gekennzeichnet, daß**
der Spiegelkörper (6) einstückig aus einem Material mit extrem niedrigem Ausdehnungskoeffizienten gefertigt ist und die beiden Meßspiegel (13ₘₓ, 13_{my}) in seine Außenseiten integriert sind.

16. Anordnung nach Anspruch 15,
**dadurch gekennzeichnet, daß**
die Meßspiegel (13ₘₓ, 13_{my}) aus separat gefertigten, dünnen Spiegelflächen-Elementen bestehen, die an dem Spiegelkörper (6) angebracht sind.

17. Anordnung nach Anspruch 16,
**dadurch gekennzeichnet, daß**
die Basisfläche der Spiegelflächen-Elemente aus demselben Material wie das des Spiegelkörpers (6) besteht.

18. Anordnung nach Anspruch 15,
**dadurch gekennzeichnet, daß**
die Meßspiegel (13ₘₓ, 13_{my}) einschichtig direkt auf die Außenseiten des Spiegelkörpers (6) aufgedampft sind.

19. Anordnung nach Anspruch 15,
**dadurch gekennzeichnet, daß**
die Meßspiegel (13ₘₓ, 13_{my}) mehrschichtig auf die Außenseiten des Spiegelkörpers (6) aufgedampft sind.

20. Anordnung nach einem der Ansprüche 2 bis 4,
**dadurch gekennzeichnet, daß**
die Bolzen (7) aus einem Material mit extrem niedrigem Ausdehnungskoeffizienten gefertigt sind.

21. Anordnung nach einem der Ansprüche 2 bis 4,
**dadurch gekennzeichnet, daß**
die Bolzen (7) in den Meßtisch (4) eingeklebt sind.

22. Anordnung nach einem der Ansprüche 2 bis 4,
**dadurch gekennzeichnet, daß**
die Bolzen (7) in den Meßtisch (4) eingepaßt sind.

23. Anordnung nach Anspruch 2 oder 3,
**dadurch gekennzeichnet, daß**
die Bolzen (7) in den Meßtisch (4) eingesintert sind.

24. Anordnung nach Anspruch 5,
**dadurch gekennzeichnet, daß**
die Bolzen (7) in den Spiegelkörper (6) eingeklebt sind.

25. Anordnung nach Anspruch 5,
**dadurch gekennzeichnet, daß**
die Bolzen (7) in den Spiegelkörper (6) eingepaßt sind.

26. Anordnung nach Anspruch 5,
**dadurch gekennzeichnet, daß**
die Bolzen (7) in den Spiegelkörper (6) eingesintert sind.

27. Anordnung nach einem der Ansprüche 2 bis 5,
**dadurch gekennzeichnet, daß**
die Bolzen (7) zylindrisch sind.

28. Anordnung nach einem der vorhergehenden Ansprüche,
**dadurch gekennzeichnet, daß**
der Meßtisch (4) , der Spiegelkörper (6) und die Aufnahme (8) übereinanderliegende, rahmenförmige Öffnungen aufweisen, so daß das auf der Aufnahme (8) aufliegende Substrat (9) von unten und oben bzw. für Auflicht- und Durchlichtanwendungen zugänglich ist.

29. Anordnung nach einem der vorhergehenden Ansprüche,
**dadurch gekennzeichnet, daß**
der Spiegelkörper (6) an seiner Oberfläche an drei Seiten eine Randerhöhung (18) mit einer besonders großen, ebenen Außenfläche zur Integration der Meßspiegel (13ₘₓ, 13_{my}) aufweist, wodurch eine einseitig offene, wannenförmige Vertiefung gebildet wird, in welche das Substrat (9) aus Richtung der offenen Seite eingeschoben und auf den oberen Auflagepunkten aufgelegt werden kann.

## Claims

1. Measurement table arrangement having a displaceable x/y coordinate measurement table (4), having a receptacle (8) for a substrate (9) to be measured, having two measurement mirrors (13ₘₓ, 13_{my}), located orthogonally to one another, as measurement reflectors of an interferometer measuring the x/y position, and having a mirror body (6) carrying the measurement mirrors (13ₘₓ, 13_{my}), **characterized in that** the measurement table (4), the mirror body (6), the receptacle (8) for the substrate (9) are embodied as separate components, the mirror body (6) having, in a surface region delimited by the measurement mirrors (13ₘₓ, 13_{my}), three mutually opposite support points respectively on its top side and underside, so that the mirror body (6) is supported on the measurement table (4) only with the lower support points and carries the receptacle (8) for the substrate (9) only with the upper support points.

2. Arrangement according to Claim 1, **characterized in that**
a) three projecting vertical studs (7) are shaped or fitted into the surface of the measurement table (4), the upper end of the first stud (7) having a conical recess (23), the upper end of the second stud (7) a V-groove (24), parallel to one outer edge of the measurement table (4), in the direction of the conical recess (23), and the upper end of the third stud (7) a flat sliding surface (25) ;
b) three cavities (27) for nonjamming reception of the studs (7) are provided in the underside of the mirror body (6); and
c) three balls (22) or three studs with hemispherical ends, which project upwards out beyond its top side and downwards into the upper ends of the cavities (27) and thereby form the support points, are fitted into the mirror body (6) above the cavities, the mirror body (6) being supported by way of the underside of the balls (22) on the conical recess (23), the V-groove (24) and the flat sliding surface of the studs (7).

3. Arrangement according to Claim 1, **characterized in that**
a) three vertical studs (7) are shaped or fitted on the top side of the measurement table (4), their upper ends respectively having a conical recess (23), a V-groove (24), parallel to one outer edge of the measurement table (4), in the direction of the conical recess (23), and a flat sliding surface (25),
b) the underside of the mirror body (6) has, for nonjamming reception of the studs (7), three cavities (27) in each of whose upper ends is countersunk a ball recess (28),
c) three balls (22), which are supported on the conical recess (23), the V-groove (24), and the flat sliding surface (25), are inserted below the conical recesses (28); and
d) three half-balls (26) are mounted, as upper support points, on the surface of the mirror body (6), above the conical recesses (28) of the cavities (27).

4. Arrangement according to Claim 1, **characterized in that**
a) three vertical studs (7), whose upper ends each have a conical recess (23), are shaped or fitted on the top side of the measurement table (4);
b) the underside of the mirror body (6) has, for nonjamming reception of the studs (7), three cavities (27) whose upper ends respectively have a conical recess, a V-groove, parallel to one outer edge of the measurement table (4), in the direction of that conical recess, and a flat sliding surface,
c) the conical recess, the V-groove, and the flat sliding surface of the cavities (27) are supported on three balls (22) forming the lower support points and are inserted into the conical recesses (23) of the studs; and
d) three half-balls (26) are mounted as upper support points on the surface of the mirror body (6) above the cavities (27).

5. Arrangement according to Claim 1, **characterized in that**
three studs (7), projecting upwards and downwards, pass vertically and in stress-free fashion through the mirror body (6) and are immovably joined to it, the ends of the studs (7) forming the upper and lower support points.

6. Arrangement according to Claim 5, **characterized in that**
the studs (7) are produced of a material having an extremely low coefficient of expansion.

7. Arrangement according to Claim 5,
**characterized in that**
the upper ends of the studs (7) possess a spherical surface as termination.

8. Arrangement according to Claim 5,
**characterized in that**
the upper ends of the studs (7) possess as termination a conical recess into which a ball is placed or adhesively bonded.

9. Arrangement according to Claim 5,
**characterized in that**
the lower ends of the studs possess a spherical surface as termination.

10. Arrangement according to Claim 9,
**characterized in that**
the lower ends of the studs (7) possess as termination a conical recess (21) into which a ball (22) is placed or adhesively bonded.

11. Arrangement according to Claim 5,
**characterized in that**
the studs (7) have, in the region below the mirror body (6), an enlargement as support (20) for the mirror body (6).

12. Arrangement according to Claim 5,
**characterized in that**
the surface of the measurement table (4) has depressions to receive one or more of the lower ends of the studs (7).

13. Arrangement according to Claim 5,
**characterized in that**
a) the lower ends of the studs (7) respectively have a conical recess (21), a V-groove (24) parallel to one outer edge of the measurement table (4), in the direction of the conical recess (21), and a flat sliding surface (25); and
b) and three conical recesses (23), into each of which a ball (22) is placed or adhesively bonded, are present in the surface of the measurement table (4) for the three studs (7).

14. Arrangement according to Claim 5,
**characterized in that**
a) all the lower ends of the studs (7) possess as termination a conical recess (21) into each of which a ball (22) is placed or adhesively bonded; and
b) there are present in the surface of the measurement table (4) a conical recess (23) for the first ball (22), a V-groove (24), parallel to one outer edge of the measurement table (4) in the direction of the conical recess (23) for the second ball (22), and a flat sliding surface (25) for the third ball (22).

15. Arrangement according to Claims 1-5,
**characterized in that**
the mirror body (6) is produced as one piece from a material having an extremely low coefficient of expansion, and the two measurement mirrors (13_{mx,} 13_{my}) are integrated into its outer sides.

16. Arrangement according to Claim 15,
**characterized in that**
the measurement mirrors (13ₘₓ, 13_{my}) comprise separately produced thin mirror surface elements which are mounted on the mirror body (6).

17. Arrangement according to Claim 16,
**characterized in that**
the base surface of the mirror surface elements consists of the same material as that of the mirror body (6).

18. Arrangement according to Claim 15,
**characterized in that**
the measurement mirrors (13_{mx,} 13_{my}) are vapour-deposited in one layer directly onto the outer sides of the mirror body (6).

19. Arrangement according to Claim 15,
**characterized in that**
the measurement mirrors (13_{mx,} 13_{my}) are vapour-deposited in one layer directly onto the outer sides of the mirror body (6).

20. Arrangement according to one of Claims 2 to 4,
**characterized in that**
the studs (7) are produced from a material having an extremely low coefficient of expansion.

21. Arrangement according to one of Claims 2 to 4,
**characterized in that**
the studs (7) are adhesively bonded into a the measurement table (4).

22. Arrangement according to one of Claims 2 to 4,
**characterized in that**
the studs (7) are fitted into the measurement table (4).

23. Arrangement according to one of Claims 2 to 3,
**characterized in that**
the studs (7) are sintered into the measurement table (4).

24. Arrangement according to Claims 5,
**characterized in that**
the studs (7) are adhesively bonded into the mirror body (6).

25. Arrangement according Claims 5,
**characterized in that**
the studs (7) are fitted into the mirror body (6).

26. Arrangement according to Claims 5,
**characterized in that**
the studs (7) are sintered into the mirror body (6).

27. Arrangement according to one of Claims 2 to 5,
**characterized in that**
the studs (7) are cylindrical.

28. Arrangement according to one of the preceding claims,
**characterized in that**
the measurement table (4), the mirror body (6) and the receptacle (8) have frame-shaped openings lying above one another, so that the substrate (9) supported on the receptacle (8) is accessible from below and above, and for reflecting-light and transmitted-light appliances.

29. Arrangement according to one of the preceding claims,
**characterized in that**
the mirror body (6) has on its surface, on three sides, an elevated rim (18) having a particularly large, flat outer surface for integration of the measurement mirrors (13_{mx,} 13_{my}), thus forming a trough-shaped depression, open on one side, into which the substrate (9) can be inserted from the direction of the open side and placed onto the upper support points.

## Revendications

1. Arrangement de table de mesure comportant une table de mesure (4) déplaçable à coordonnées x/y, un support (8) pour un substrat à mesurer (9), deux miroirs de mesure (13ₘₓ, 13_{my}) placés de manière orthogonale l'un par rapport à l'autre et servant de réflecteurs de mesure d'un interféromètre mesurant la position x/y et un corps réflecteur (6) supportant les miroirs de mesure (13ₘₓ, 13 _{my}),
**caractérisé en ce que**
la table de mesure (4), le corps réflecteur (6) et le support (8) pour le substrat (9) sont réalisés sous forme d'éléments de construction séparés, le corps réflecteur (6) présentant, sur son côté supérieur et inférieur, dans une zone surfacique encadrée par les miroirs de mesure (13ₘₓ, 13 _{my}), à chaque fois trois points d'appui opposés, de sorte que le corps réflecteur (6) ne repose sur la table de mesure (4) que par les points d'appui inférieurs et ne soutient le support (8) destiné au substrat (9) que par les points d'appui supérieurs.

2. Arrangement selon la revendication 1,
**caractérisé en ce que**
a) dans la surface de la table de mesure (4) sont formés ou ajustés trois goujons verticaux proéminents (7), l'extrémité supérieure du premier goujon (7) présentant un retrait conique (23), l'extrémité supérieure du deuxième goujon (7) une rainure en V (24) parallèle au bord extérieur de la table de mesure (4) en direction du retrait conique (23) et l'extrémité supérieure du troisième goujon (7) une surface de glissement plane (25),
b) dans le côté inférieur du corps réflecteur (6) sont prévues trois cavités (27) servant à recevoir sans blocage les goujons (7),
c) et au dessus des cavités sont ajustées dans le corps réflecteur (6) trois billes (22) ou trois goujons comportant des extrémités en forme de demi-sphères qui dépassent vers le haut au-delà son côté supérieur et vers le bas dans les extrémités supérieures des cavités (27) et constituent ainsi les points d'appui, le corps réflecteur (6) s'appuyant par le côté inférieur des billes (22) sur le retrait conique (23), la rainure en V (24) et la surface de glissement plane des goujons (7).

3. Arrangement selon la revendication 1,
**caractérisé en ce que**
a) dans la surface de la table de mesure (4) sont formés ou ajustés trois goujons verticaux (7), dont les extrémités supérieures présentent chacune un retrait conique (23), une rainure en V (24) parallèle au bord extérieur de la table de mesure (4) en direction du retrait conique (23) et une surface de glissement plane (25),
b) le côté inférieur du corps réflecteur (6) présente trois cavités (27) destinées à recevoir sans blocage les goujons (7), à l'extrémité supérieure desquelles est pratiqué respectivement un retrait conique (28),
c) sous les retraits coniques (28) sont insérées trois billes (22) formant les points d'appui inférieurs, qui s'appuient sur le retrait conique (23), la rainure en V (24) et la surface de glissement plane (25),
d) et à la surface du corps réflecteur (6) sont installées, au-dessus des retraits coniques (28) des cavités (27), trois demi-billes (26) servant de points d'appui supérieurs.

4. Arrangement selon la revendication 1,
**caractérisé en ce que**
a) dans la surface de la table de mesure (4) sont formés ou ajustés trois goujons verticaux (7), dont les extrémités supérieures présentent respectivement un retrait conique (23),
b) le côté inférieur du corps réflecteur (6) présente, aux fins de recevoir sans blocage les goujons (7), trois cavités (27) dont les extrémités supérieures présentent chacune un retrait conique, une rainure en V (24) parallèle à un bord extérieur de la table de mesure (4) en direction de ce retrait conique et une surface de glissement plane,
c) le retrait conique, la rainure en V et la surface de glissement plane des cavités (27) s'appuient sur trois billes (22) constituant les points d'appui inférieurs, qui sont insérées dans les retraits coniques (23) des goujons,
d) et à la surface du corps réflecteur (6) sont prévues au-dessus des cavités (27) trois demi-billes (26) servant de points d'appui supérieurs.

5. Arrangement selon la revendication 1,
**caractérisé en ce que**
trois goujons (7) proéminents vers le haut et le bas sont guidés verticalement et sans tension à travers le corps réflecteur (6) et sont reliés fixement à celui-ci, les extrémités des goujons (7) constituant les points d'appui supérieurs et inférieurs.

6. Arrangement selon la revendication 5,
**caractérisé en ce que**
les goujons (7) sont fabriqués dans une matière à coefficient d'extension extrêmement bas.

7. Arrangement selon la revendication 5,
**caractérisé en ce que**
les extrémités supérieures des goujons (7) se terminent par une surface de bille.

8. Arrangement selon la revendication 5,
**caractérisé en ce que**
les extrémités supérieures des goujons (7) se terminent par un retrait conique dans lequel est déposée ou collée une bille.

9. Arrangement selon la revendication 5,
**caractérisé en ce que**
les extrémités inférieures des goujons se terminent par une surface de bille.

10. Arrangement selon la revendication 9,
**caractérisé en ce que**
les extrémités inférieures des goujons (7) se terminent par un retrait conique (21) dans lequel est déposée ou collée une bille (22).

11. Arrangement selon la revendication 5,
**caractérisé en ce que**
les goujons (7) présentent, dans la zone située en dessous du corps réflecteur (6), un élargissement servant de support (20) pour le corps réflecteur (6).

12. Arrangement selon la revendication 5,
**caractérisé en ce que**
la surface de la table de mesure (4) présente des renfoncements destinés à recevoir une ou plusieurs des extrémités inférieures des goujons (7).

13. Arrangement selon la revendication 5,
**caractérisé en ce que**
a) chaque extrémité inférieure des goujons (7) présente un retrait conique (21), une rainure en V (24) parallèle à un bord extérieur de la table de mesure (4) en direction du retrait conique (21) et une surface de glissement plane (25),
b) et dans la surface de la table de mesure (4) sont prévus pour les trois goujons (7) trois retraits coniques (23) dans lesquels est respectivement déposée ou collée une bille (22).

14. Arrangement selon la revendication 5,
**caractérisé en ce que**
a) toutes les extrémités inférieures des goujons (7) se terminent par un retrait conique (21) dans lequel est déposée ou collée respectivement une bille (22),
b) et dans la surface de la table de mesure (4) est prévue pour la première bille (22) un retrait conique (23), pour la deuxième bille (22) une rainure en V (24) parallèle au bord extérieur de la table de mesure (4) en direction du retrait conique (23) et pour la troisième bille (22) une surface de glissement plane (25).

15. Arrangement selon les revendications 1 à 5,
**caractérisé en ce que**
le corps réflecteur (6) est fabriqué en une pièce à partir d'une matière à coefficient d'extension extrêmement bas et que les deux miroirs de mesure (13ₘₓ, 13_{my}) sont intégrés dans ses côtés extérieurs.

16. Arrangement selon la revendication 15,
**caractérisé en ce que**
les miroirs de mesure (13ₘₓ, 13_{my}) consistent en éléments minces à surface réfléchissante fabriqués séparément qui sont installés sur le corps réflecteur (6).

17. Arrangement selon la revendication 16,
**caractérisé en ce que**
la surface de base des éléments à surface réfléchissante est composée de la même matière que celle du corps réflecteur (6).

18. Arrangement selon la revendication 15,
**caractérisé en ce que**
les miroirs de mesure (13ₘₓ, 13_{my}) sont vaporisés en une couche directement sur les côtés extérieurs du corps réflecteur (6).

19. Arrangement selon la revendication 15,
**caractérisé en ce que**
les miroirs de mesure (13ₘₓ, 13_{my}) sont vaporisés en plusieurs couches sur les côtés extérieurs du corps réflecteur (6).

20. Arrangement selon une des revendications 2 à 4,
**caractérisé en ce que**
les goujons (7) sont fabriqués à partir d'une matière à coefficient d'extension extrêmement bas.

21. Arrangement selon une des revendications 2 à 4,
**caractérisé en ce que**
les goujons (7) sont collés dans la table de mesure (4).

22. Arrangement selon une des revendications 2 à 4,
**caractérisé en ce que**
les goujons (7) sont ajustés dans la table de mesure (4).

23. Arrangement selon la revendication 2 ou 3,
**caractérisé en ce que**
les goujons (7) sont frittés dans la table de mesure (4).

24. Arrangement selon la revendication 5,
**caractérisé en ce que**
les goujons (7) sont collés dans le corps réflecteur (6).

25. Arrangement selon la revendication 5,
**caractérisé en ce que**
les goujons (7) sont ajustés dans le corps réflecteur (6).

26. Arrangement selon la revendication 5,
**caractérisé en ce que**
les goujons (7) sont frittés dans le corps réflecteur (6).

27. Arrangement selon une des revendications 2 à 5,
**caractérisé en ce que**
les goujons (7) sont cylindriques.

28. Arrangement selon une des revendications précédentes,
**caractérisé en ce que**
la table de mesure (4), le corps réflecteur (6) et le support (8) présentent des orifices superposés en forme de cadres, de sorte que le substrat (9) reposant sur le support (8) est accessible par le bas et par le haut ou pour des applications à éclairage par le dessus ou en transparence.

29. Arrangement selon une des revendications précédentes,
**caractérisé en ce que**
le corps réflecteur (6) présente à sa surface, sur trois côtés, une surélévation du bord (18) comportant une surface extérieure plane particulièrement étendue pour l'intégration des miroirs de mesure (13ₘₓ, 13_{my}), ce qui constitue un renfoncement en forme de cuvette ouvert d'un côté dans lequel le substrat (9) peut être glissé en provenance du côté ouvert et posé sur les points d'appui supérieurs.
